# EUROPÄISCHE PATENTSCHRIFT

(11) **EP 0 946 998 B1**
(45) Veröffentlichungstag und Bekanntmachung des Hinweises auf die Patenterteilung: **06.04.2005**
(21) Anmeldenummer: 97935452.9
(22) Anmeldetag: 22.07.1997
(51) Int. Cl.: H01L 41/04

(54) **VORRICHTUNG UND VERFAHREN ZUM ANSTEUERN WENIGSTENS EINES KAPAZITIVEN STELLGLIEDES**
DEVICE AND PROCESS FOR CONTROLLING OF AT LEAST ONE CAPACITATIVE ACTUATOR
DISPOSITIF ET PROCEDE POUR LA COMMANDE D'AU MOINS UN ACTIONNEUR CAPACITIF

(30) Priorität: 14.08.1996 DE 19632837
(43) Veröffentlichungstag der Anmeldung: 06.10.1999
(73) Patentinhaber: SIEMENS AKTIENGESELLSCHAFT, 80333 München (DE)
(72) Erfinder: HOFFMANN, Christian, D-93057 Regensburg (DE); FREUDENBERG, Hellmut, D-93080 Pentling (DE); GERKEN, Hartmut, D-93152 Nittendorf (DE); HECKER, Martin, D-93336 Laimerstadt (DE); PIRKL, Richard, D-93053 Regensburg (DE)
(86) Internationale Anmeldenummer: PCT/DE1997/001540
(87) Internationale Veröffentlichungsnummer: WO 1998/007197

(56) Entgegenhaltungen:
- US-A- 5 130 598

## Beschreibung

Die Erfindung betrifft eine Vorrichtung zum Ansteuern wenigstens eines kapazitiven Stellgliedes mittels einer Steuerschaltung, insbesondere eines piezoelektrisch betriebenen Kraftstoffeinspritzventils einer Brennkraftmaschine, gemäß den Merkmalen des Patentanspruchs 1 oder 2. Die Erfindung betrifft auch ein Verfahren zum Betreiben dieser Vorrichtung.

Aus EP 0 464 443 A1 ist ein Piezo-Stellglied bekannt, welches aus einem Kondensator über eine Ladespule geladen wird. Ein Teil der aufgebrachten Energie wird beim Entladen des Piezo-Stellgliedes über eine Entladespule in den Kondensator zurückgespeist, während der letzte Teil, ebenfalls über die Entladespule, durch Kurzschließen vernichtet wird. Beim Entladen liegt am Piezo-Stellglied eine negative Spannung.

Aus DE 36 21 541 A1 ist eine Treiberschaltung für ein Piezostellglied eines Kraftstoffeinspritzventils bekannt, welches über eine an einer Spannungsquelle liegende Reihenschaltung zweier Kondensatoren und eine Ladespule geladen und über eine Entladespule in einen der beiden Kondensatoren entladen wird. Bei einer alternativen Ausführung wird das Stellglied über einen an einer Spannungsquelle liegenden Kondensator und eine Ladespule geladen; beim Entladen wird die im Piezostellglied gespeicherten Energieund über eine Entladespule vernichtet.

Der Erfindung liegt die Aufgabe zugrunde, eine möglichst verlustarm arbeitende und einfach aufgebaute Vorrichtung zum Ansteuern wenigstens eines kapazitiven Stellgliedes zu schaffen, an dem keine negative Spannung auftreten soll.

Diese Aufgabe wird erfindungsgemäß durch die Merkmale des Patentanspruchs 1 oder 2 gelöst. Vorteilhafte Ausgestaltungen der Erfindung sind den Unteransprüchen zu entnehmen.

Von Vorteil ist unter anderem, daß die Spannungsquelle für eine Ausgangsspannung ausgelegt sein kann, die geringer als die Ladespannung für ein Stellglied ist, und daß das Laden und Entladen jedes Stellgliedes mit einer kompletten Sinushalbschwingung des Stromes erfolgt. Dadurch erreicht das Stellglied seine Betriebsspannung und damit seinen Endhub mit "langsamer" Geschwindigkeit (im Maximalwert einer Cosinusschwingung). Dadurch entstehen im Frequenzspektrum nur Frequenzen unterhalb einer Grundfrequenz von - beim Betrieb eines piezoelektrisch betriebenen Kraftstoffeinspritzventils - maximal 300Hz, wodurch kaum EMV-Probleme entstehen. Durch Spannungsregelung der Spannungsquelle, vorzugsweise eines Schaltnetzteils, erfolgt eine einfache Aufladung des Stellgliedes. Es sind auch keine Nachladeelemente erforderlich, da die Spannungsquelle immer mit dem Ladekondensator verbunden ist. Außerdem kann die Umschwingspule aus einem für die Schaltung vorgesehenen Gehäuse näher zu den Stellgliedern verlagert werden, da zwischen ihr und den Stellgliedern kein Schalter angeordnet ist.

Ausführungsbeispiele der Erfindung sind im folgenden unter Bezugnahme auf die schematische Zeichnung näher erläutert. Es zeigen:
- Figur 1:: die Schaltung eines erstes Ausführungsbeispiels,
- Figur 2:: ein Flußdiagramm dazu, und

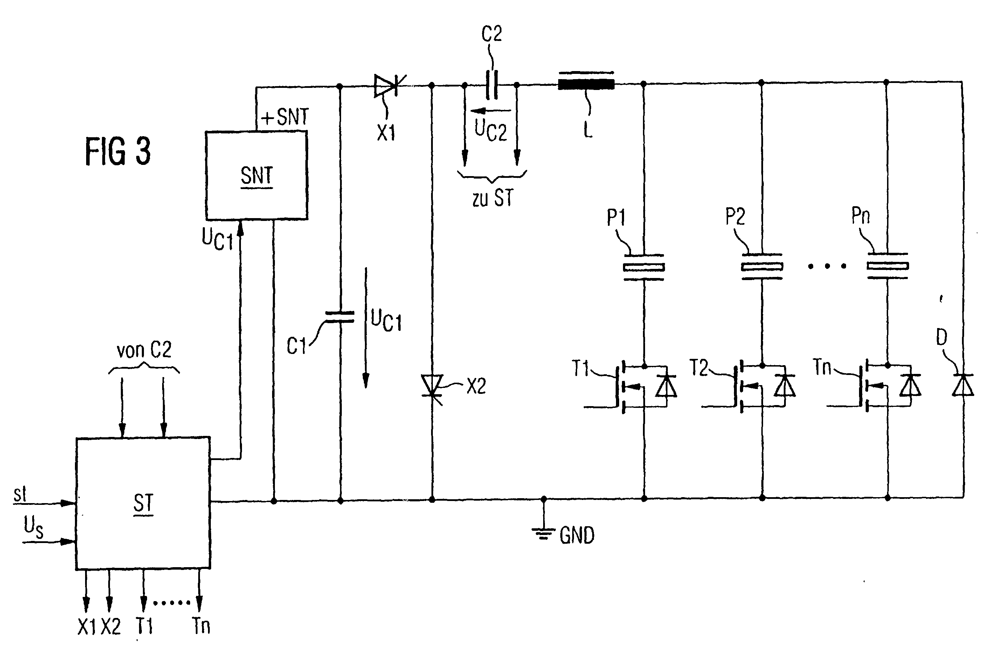

- Figur 3:: die Schaltung eines zweiten Ausführungsbeispiels.

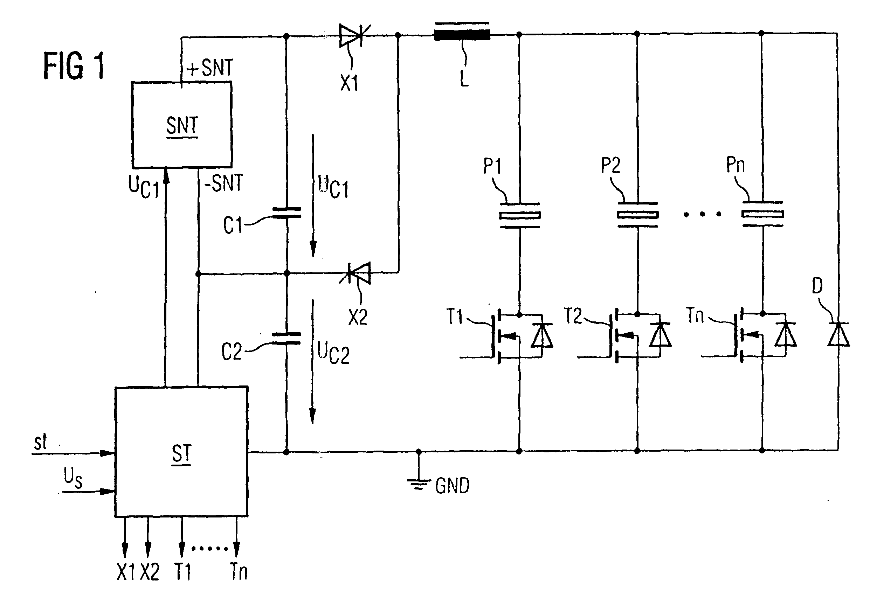

Figur 1 zeigt die Schaltung eines ersten Ausführungsbeispiels nach der Erfindung zum Ansteuern von weiter nicht dargestellten n Kraftstoffeinspritzventilen einer Brennkraftmaschine über piezoelektrische Stellglieder P1 bis Pn mittels einer Steuerschaltung ST, die Teil eines weiter nicht dargestellten mikroprozessor-gesteuerten Motorsteuergerätes ist.

Zwischen dem Pluspol +SNT und dem Minuspol -SNT einer geregelten, massepotentialfreien Spannungsquelle SNT, vorzugsweise eines Schaltnetzteils, ist ein Ladekondensator C1 angeschlossen. Parallel zum Ladekondensator C1 ist eine Reihenschaltung aus einem mit dem Pluspol +SNT verbundenen, von ihm weg stromdurchlässigen Ladeschalter X1 und einem mit dem Minuspol -SNT verbundenen, zu ihm hin stromdurchlässigen Entladeschalter X2 angeordnet.

Wenn von Schaltern X1 und X2 die Rede ist, handelt es sich um elektronische, nur in einer Richtung stromdurchlässige, aus wenigstens einem Halbleiterelement bestehende Schalter, vorzugsweise Thyristorschalter, die von der Steuerschaltung leitend gesteuert werden.

Zwischen dem massepotentialfreien Minuspol -SNT des Schaltnetzteils und einem Masseanschluß GND der Schaltung ist ein Umladekondensator C2 angeordnet.

Zwischen dem Verbindungspunkt von Ladeschalter X1 und Entladeschalter X2 und dem Masseanschluß GND liegt eine Reihenschaltung aus einer mit dem Ladeschalter X1 verbundenen Umschwingspule L, einem ersten Stellglied P1 und einem ersten, gesteuerten Power-MOSFET-Schalter T1.

Parallel zur Reihenschaltung aus dem Stellglied P1 und dem Power-MOSFET-Schalter T1 ist eine vom Masseanschluß GND zur Umschwingspule L hin stromdurchlässige Diode D angeordnet.

Für jedes weitere Stellglied P2 bis Pn ist eine Reihenschaltung aus diesem Stellglied und einem weiteren Power-MOSFET-Schalter T2 bis Tn der Reihenschaltung aus dem ersten Stellglied P1 und dem ersten Power-MOSFET-Schalter T1 parallel geschaltet.

Power-MOSFET-Schalter enthalten üblicherweise Inversdioden, deren Funktion, wie weiter unten näher erläutert, beim Betrieb der erfindungsgemäßen Vorrichtung benutzt wird.

Die Schalter X1, X2 und T1 bis Tn werden von der Steuerschaltung ST, abhängig von Steuersignalen st des Motorsteuergerätes, von einem in diesem Ausführungsbeispiel in der Steuerschaltung ST gespeicherten oder ihr vom Motorsteuergerät zugeführten Sollwert U_{S} für die Spannung, mit welcher die Stellglieder P1 bis Pn aufgeladen werden sollen, und vom Istwert U_{C2} der Spannung am Umladekondensator C2 gesteuert. Der Anschluß des massefreien Minuspols -SNT dient zugleich als Spannungsmeßpunkt für die am Umladekondensator C2 anliegende Spannung U_{C2}. Der Ladekondensator C1 kann als Ausgangskondensator des Schaltnetzteils SNT betrachtet werden.

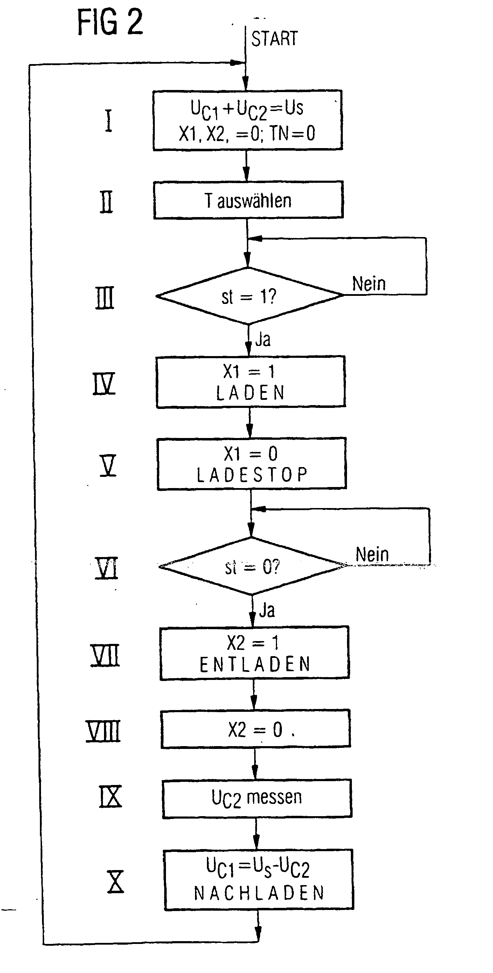

Ein Verfahren zum Betreiben der beschriebenen Vorrichtung wird nachstehend anhand der Figur 2 näher erläutert. Auf die Kästen I bis X der Figur 2 wird im folgenden Text nur durch römische Zahlen hingewiesen.

Ausgehend von einem Zustand I, in welchem beispielsweise der Ladekondensator C1 auf U_{C1} = +60V und der Umladekondensator C2 auf U_{C2} = +100V, , zusammen in Reihenschaltung also auf eine Sollspannung U_{S} = +160V aufgeladen sind, die Umschwingspule L stromlos ist, alle Schalter X1, X2 und T1 bis Tn nichtleitend (hochohmig) und alle Stellglieder P1 bis Pn entladen sind, soll das Stellglied P1 betätigt werden, um über das zugeordnete Einspritzventil Kraftstoff in einen Zylinder einzuspritzen. Der Wert der Sollspannung U_{S} ist in der Steuerschaltung ST gespeichert oder wird ihr vom nicht dargestellten Motorsteuergerät vorgegeben.

zunächst wählt die Steuerschaltung das entsprechende Stellglied aus (II), indem sie den ihm zugeordneten Power-MOSFET-Schalter T1 leitend steuert. T1 kann über einen Kurbelwellenwinkel KW = 720°KW/Z (Z = Zahl der Zylinder) leitend (niederohmig) bleiben, das sind beispielsweise bei Vierzylindermotoren 180°KW und bei Sechszylindermotoren 120°KW.

Bei Einspritzbeginn, der durch den Beginn eines Steuersignals st vorgegeben wird (III), wird von der Steuerschaltung ST der Ladeschalter X1 gezündet (IV). Dadurch entlädt sich die an der Reihenschaltung aus C1 und C2 liegende Spannung U_{S} = +160V (siehe oben) während einer kompletten Sinushalbschwingung über die Umschwingspule I in das Stellglied P1 und dieses öffnet das nicht dargestellte Einspritzventil. Die Spannungsquelle - das Schaltnetzteil SNT - bleibt mit dem Ladekondensator C1 verbunden, so daß auch sie Energie in den Umschwingkreis einspeist.

Nach dem Umschwingen verlischt der Ladeschalter X1 (V), das Stellglied P1 bleibt geladen. Am Umladekondensator C2 verbleibt eine von der Kapazität abhängige negative Restspannung (z.B. -10V), die erforderlich ist, um das Stellglied P1 beim Entladen wieder vollständig entleeren zu können.

Zum Entladen des Stellgliedes am Ende eines Steuersignals st (VI) wird der Entladeschalter X2 gezündet (VII). Der Entladestromkreis schließt sich über die Inversdiode des Power-MOSFET-Schalters T1. Die im Stellglied gespeicherte Energie schwingt über die Umschwingspule L in den Kondensator C2 zurück, der beispielsweise wieder auf U_{C2} = +100V geladen wird, und kann für den folgenden Zyklus genutzt werden. Sobald das Stellglied auf die Schwellspannung der dem "aktiven" Kanal parallel liegenden Diode D entladen ist, setzt sich der noch fließende Strom über diese Diode fort,wodurch ein Aufladen des Stellgliedes auf eine negative Spannung verhindert wird. Anschließend verlischt der Entladeschalter X2 (VIII).

Für den Ladezyklus des nächsten Stellgliedes müssen zunächst die entstandenen Verluste ausgeglichen werden. Dazu wird die am Minuspol -SNT des Schaltnetzteils SNT abgreifbare Spannung U_{C2} des Umladekondensators C2 gemessen (IX) und anschließend das Schaltnetzteil SNT auf einen Ausgangsspannungswert eingestellt (geregelt), der der Differenz zwischen Sollwert U_{S} = 60V und gemessener Spannung U_{C2} = 100V entspricht. Auf diese Spannung U_{C1} wird der mit dem Schaltnetzteil verbundene Ladekondensator C1 dementsprechend nachgeladen (X). Damit steht für den nächsten Ladevorgang an der Reihenschaltung der Kondensatoren C1 und C2 wieder die volle Spannung U_{S} = +160V zur Verfügung (I).

Wird die Vorrichtung nach längerer Pause in Betrieb genommen, so ist zunächst der Umladekondensator C2 entladen und der Ladekondensator C1 wird auf maximale Ausgangsspannung des Schaltnetzteils SNT aufgeladen, beispielsweise +75V. Es findet ein Einschwingvorgang statt, der einige Ladezyklen dauert, bis die beim Entladen des Stellgliedes rückgelieferte Spannung am Umschwingkondensator C2 nach jedem Umschwingvorgang den angenommenen "stationären" Wert U_{C2} = +100V erreicht.

Das Ausführungsbeispiel der Vorrichtung nach Figur 2, dessen Arbeitweise vollkommen derjenigen der Vorrichtung nach Figur 1 entspricht, unterscheidet sich nur in wenigen Punkten von dem Ausführungsbeispiel nach Figur 1,. Der Unterschied ist, daß hier der Minuspol des Schaltnetzteils SNT mit dem Masseanschluß GND der Schaltung verbunden ist und daß dementsprechend der Umladekondensator C2 auf einen Platz zwischen dem Verbindungspunkt des Ladeschalters X1 mit dem Entladeschalter X2 und der Umschwingspule L versetzt ist.

Mit dem Bezugspotential auf Masse vereinfacht sich die Entwicklung des Schaltnetzteils. Mit dieser Schaltungsauslegung erhält auch der Entladeschalter X2 einen Masseanschluß, wodurch sich seine Ansteuerung ohne einen zusätzlichen Wandler durchführen läßt.

## Patentansprüche

1. Vorrichtung zum Ansteuern wenigstens eines kapazitiven Stellgliedes (P1 bis Pn) mittels einer Steuerschaltung (ST), insbesondere eines piezoelektrisch betriebenen Kraftstoffeinspritzventils einer Brennkraftmaschine,
- mit einem zwischen Pluspol (+SNT) und Minuspol (-SNT) einer von der Steuerschaltung (ST) regelbaren, massepotentialfreien Spannungsquelle (SNT) angeordneten und von ihr aufladbaren Ladekondensator (C1),
- mit einer parallel zum Ladekondensator (C1) angeordneten Reihenschaltung aus einem mit dem Pluspol (+SNT) verbundenen, von ihm weg stromdurchlässigen Ladeschalter (X1) und einem mit dem Minuspol (-SNT) verbundenen, zu ihm hin stromdurchlässigen Entladeschalter (X2),
- mit einem zwischen dem Minuspol (-SNT) und einem Masseanschluß (GND) angeordneten Umladekondensator (C2),
- mit einer zwischen dem Verbindungspunkt von Ladeschalter (X1) und Entladeschalter (X2) und dem Masseanschluß (GND) liegenden Reihenschaltung aus einer mit dem Ladeschalter (X1) verbundenen Umschwingspule (L), einem ersten Stellglied (P1) und einem ersten, gesteuerten Power-MOSFET-Schalter (T1),
- wobei für jedes weitere Stellglied eine Reihenschaltung aus diesem Stellglied (P2 bis Pn) und einem weiteren Power-MOSFET-Schalter (T2 bis Tn) der Reihenschaltung aus dem ersten Stellglied (P1) und dem ersten Power-MOSFET-Schalter(T1) parallel geschaltet ist, und
- mit einer parallel zu allen Reihenschaltungen aus Stellglied und Power-MOSFET-Schalter angeordneten, vom Masseanschluß (GND) zur Umschwingspule (L) hin stromdurchlässigen Diode (D).

2. Vorrichtung zum Ansteuern wenigstens eines kapazitiven Stellgliedes (P1 bis Pn) mittels einer Steuerschaltung (ST), insbesondere eines piezoelektrisch betriebenen Kraftstoffeinspritzventils einer Brennkraftmaschine,
- mit einem zwischen Pluspol (+SNT) und Minuspol (GND) einer von der Steuerschaltung (ST) regelbaren Spannungsquelle (SNT) angeordneten und von ihr aufladbaren Ladekondensator (C1),
- mit einer parallel zum Ladekondensator (C1) angeordneten Reihenschaltung aus einem mit dem Pluspol (+SNT) verbundenen, von ihm weg stromdurchlässigen Ladeschalter (X1) und einem mit dem Minuspol (GND) verbundenen, zu ihm hin stromdurchlässigen Entladeschalter (X2),
- mit einer zwischen dem Verbindungspunkt von Ladeschalter (X1) und Entladeschalter (X2) und dem Masseanschluß (GND) liegenden Reihenschaltung aus einem mit dem Ladeschalter (X1) verbundenen Umladekondensator (C2), einer Umschwingspule (L), einem ersten Stellglied (P1) und einem ersten, gesteuerten Power-MOSFET-Schalter(T1),
- mit einer der Reihenschaltung des ersten Stellgliedes (P1) und des ersten Power-MOSFET-Schalters (T1) parallel geschalteten, für jedes weitere Stellglied vorgesehenen Reihenschaltung aus diesem Stellglied (P2 bis Pn) und einem weiteren Power-MOSFET-Schalter (T2 bis Tn), und
- mit einer parallel zu allen Reihenschaltungen aus Stellglied und Power-MOSFET-Schalter angeordneten, vom Masseanschluß (GND) zur Umschwingspule (L) hin stromdurchlässigen Diode (D).

3. Vorrichtung nach Anspruch 1, **dadurch gekennzeichnet, daß** der Anschluß des massefreien-Minuspols (-SNT) als Spannungsmeßpunkt für die am Umladekondensator (C2) anliegende Spannung (U_{C2}) dient.

4. Vorrichtung nach einem der Ansprüche 1 oder 2, **dadurch gekennzeichnet, daß** die von der Steuerschaltung (ST) regelbare Spannungsquelle (SNT) ein Schaltnetzteil ist.

5. Vorrichtung nach einem der Ansprüche 1 oder 2, **dadurch gekennzeichnet, daß** die Steuerschaltung (ST) ein Teil eines mikroprozessorgesteuerten Motorsteuergerätes ist.

6. Vorrichtung nach einem der Ansprüche 1 oder 2, **dadurch gekennzeichnet, daß** Ladeschalter (X1) und Entladeschalter (X2) gesteuerte, elektronische, nur in einer Richtung stromdurchlässige Schalter mit wenigstens einem Halbleiterelement sind.

7. Verfahren zum Betreiben der Vorrichtung nach einem der Ansprüche 1 oder 2, **dadurch gekennzeichnet,**
**daß** das jeweils zu betreibende Stellglied (P1 bis Pn) über die Umschwingspule (L) mit einer vorgegebenen Sollspannung (U_{S}) aus der Reihenschaltung des Ladekondensators (C1) und des Umladekondensators (C2) geladen wird, und in den Umladekondensator (C2) wieder entladen wird, und
**daß** vor dem nächsten Ladezyklus der Ladekondensator (C1) auf eine der Differenz zwischen der Sollspannung (U_{S}) und der Spannung (U_{C2}) am Umladekondensator (C2) entsprechende Spannung (U_{C1} = U_{S} - U_{C2}) aufgeladen wird.

## Claims

1. Device for driving at least one capacitive actuator (P1 to Pn) by means of a control circuit (ST) , in particular of a piezoelectrically operated fuel injection valve of an internal combustion engine,
- having a charge capacitor (C1), which is arranged between the positive pole (+SNT) and negative pole (-SNT) of an earth potential-free voltage source (SNT) which can be regulated by the control circuit (ST), and can be charged by said voltage source (SNT),
- having a series circuit, which is arranged in parallel with the charge capacitor (C1) and comprises a charge switch (X1), which is connected to the positive pole (+SNT) and through which current can flow away from said pole (+SNT), and a discharge switch (X2), which is connected to the negative pole (-SNT) and through which current can flow to said pole (-SNT),
- having a recharge capacitor (C2), arranged between the negative pole (-SNT) and an earth connection (GND),
- having a series circuit which lies between the connection point of the charge switch (X1) and discharge switch (X2) and the earth connection (GND) and comprises a ringed-around coil (L), which is connected to the charge switch (X1), a first actuator (P1) and a first, controlled power MOSFET switch (T1),
- in which case, for each further actuator, a series circuit comprising this actuator (P2 to Pn) and a further power MOSFET switch (T2 to Tn) is connected in parallel with the series circuit comprising the first actuator (P1) and the first power MOSFET switch (T1), and
- having a diode (D) which is arranged in parallel with all the series circuits comprising actuator and power MOSFET switch, and through which current can flow from the earth connection (GND) to the ringed-around coil (L).

2. Device for driving at least one capacitive actuator (P1 to Pn) by means of a control circuit (ST), in particular of a piezoelectrically operated fuel injection valve of an internal combustion engine,
- having a charge capacitor (C1), which is arranged between the positive pole (+SNT) and negative pole (-SNT) of an earth potential-free voltage source (SNT) which can be regulated by the control circuit (ST), and can be charged by said voltage source (SNT),
- having a series circuit, which is arranged in parallel with the charge capacitor (C1) and comprises a charge switch (X1), which is connected to the positive pole (+SNT) and through which current can flow away from said pole (+SNT), and a discharge switch (X2), which is connected to the negative pole (-SNT) and through which current can flow to said pole (-SNT),
- having a series circuit, which lies between the connection point of the charge switch (X1) and discharge switch (X2) and the earth connection (GND) and comprises a recharge capacitor (C2), which is connected to the charge switch (X1), a ringed-around coil (L), a first actuator (P1) and a first, controlled power MOSFET switch (T1),
- having a series circuit, which is connected in parallel with the series circuit of the first actuator (P1) and of the first power MOSFET switch (T1), is provided for each further actuator and comprises this actuator (P2 to Pn) and a further power MOSFET switch (T2 to Tn), and
- having a diode (D) which is arranged in parallel with all the series circuits comprising actuator and power MOSFET switch, and through which current can flow from the earth connection (GND) to the ringed-around coil (L).

3. Device according to Claim 1, **characterized in that** the connection of the unearthed negative pole (-SNT) serves as voltage measuring point for the voltage (U_{C2}) applied to the recharge capacitor (C2).

4. Device according to one of Claims 1 or 2, **characterized in that** the voltage source (SNT), which can be regulated by the control circuit (ST), is a switched-mode power supply.

5. Device according to one of Claims 1 or 2, **characterized in that** the control circuit (ST) is part of a microprocessor-controlled engine control unit.

6. Device according to one of Claims 1 or 2, **characterized in that** the charge switch (X1) and discharge switch (X2) are controlled, electronic switches through which current can flow in only one direction and have at least one semiconductor element.

7. Method for operating the device according to one of Claims 1 or 2, **characterized in that** the actuator (P1 to Pn) which is to be respectively operated is charged via the ring-around coil (L) with a prescribed desired voltage (U_{S}) from the series circuit of the charge capacitor (C1) and of the recharge capacitor (C2), and is discharged again into the recharge capacitor (C2), and **in that**, before the next charge cycle, the charge capacitor (C1) is charged to a voltage (U_{C1} = U_{S} - U_{C2}) corresponding to the difference between the desired voltage (U_{S}) and the voltage (U_{C2}) at the recharge capacitor (C2).

## Revendications

1. Dispositif pour la commande d'au moins un actionneur capacitif (P₁ à Pₙ) au moyen d'un circuit de commande (ST), en particulier une soupape d'injection de carburant d'un moteur à combustion interne actionnée par effet piézoélectrique,
comprenant un condensateur de charge (C1) disposé entre un pôle positif (+SNT) et un pôle négatif (-SNT) d'une source de tension (SNT) exempte de tout potentiel de masse et réglable par le circuit de commande (ST), le condensateur de charge (C1) étant rechargeable à partir de la source de tension (SNT),
comprenant un montage en série composé d'un interrupteur de charge (X1) et d'un interrupteur de décharge (X2), l'interrupteur de charge (X1) étant relié avec le pôle positif (+SNT) et laissant passer le courant venant de celui-ci et l'interrupteur de décharge (X2) étant relié avec le pôle négatif (-SNT) et laissant passer le courant vers celui-ci, le montage en série et le condensateur de charge (C1) étant montés en parallèle,
comprenant un condensateur de transfert (C2) disposé entre le pôle négatif (-SNT) et une borne de masse (GND),
comprenant un montage en série composé d'une bobine d'oscillation (L) reliée avec l'interrupteur de charge (X1), d'un premier actionneur (P₁) et d'un premier interrupteur de puissance MOSFET (T₁) commandé, le montage en série étant disposé entre le point de connexion de l'interrupteur de charge (X1) et l'interrupteur de décharge (X2) et la borne de masse (GND),
dans lequel pour chaque actionneur supplémentaire, un montage en série composé de cet actionneur (P₂ à Pₙ) et d'un interrupteur de puissance MOSFET (T₂ à Tₙ) supplémentaire, est monté en parallèle avec le montage en série du premier actionneur (P₁) et du premier interrupteur de puissance MOSFET (T₁), et
comprenant une diode (D) montée en parallèle avec tous les montages en série composés d'actionneur et d'interrupteur de puissance MOSFET et laissant passer le courant de la borne de masse (GND) vers la bobine d'oscillation (L).

2. Dispositif pour la commande d'au moins un actionneur capacitif (P₁ à Pₙ) au moyen d'un circuit de commande (ST), en particulier une soupape d'injection de carburant d'un moteur à combustion interne actionnée par effet piezoélectrique,
comprenant un condensateur de charge (C1) disposé entre un pôle positif (+SNT) et un pôle négatif (GND) d'une source de tension (SNT) réglable par le circuit de commande (ST), le condensateur de charge (C1) étant rechargeable à partir de la source de tension (SNT),
comprenant un montage en série composé d'un interrupteur de charge (X1) et d'un interrupteur de décharge (X2), l'interrupteur de charge (X1) étant relié avec le pôle positif (+SNT) et laissant passer le courant venant de celui-ci et
l'interrupteur de décharge (X2) étant relié avec le pôle négatif (GND) et laissant passer le courant vers celui-ci, le montage en série et le condensateur de charge (C1) étant montés en parallèle,
comprenant un montage en série composé d'un condensateur de transfert (C2) relié avec l'interrupteur de charge (X1), d'une bobine d'oscillation (L), d'un premier actionneur (P₁) et d'un premier interrupteur de puissance MOSFET (T₁) commandé, le montage en série étant disposé entre le point de connexion de l'interrupteur de charge (X1) et l'interrupteur de décharge (X2) et la borne de masse (GND),
comprenant un montage en série prévu pour chaque actionneur supplémentaire composé de cet actionneur (P₂ à Pₙ) et d'un interrupteur de puissance MOSFET supplémentaire (T₂ à Tₙ), le montage en série étant monté en parallèle avec le montage en série du premier actionneur (P₁) et du premier interrupteur de puissance MOSFET (T₁), et
comprenant une diode (D) montée en parallèle avec tous les montages en série composés d'actionneur et d'interrupteur de puissance MOSFET et laissant passer le courant de la borne de masse (GND) vers la bobine d'oscillation (L).

3. Dispositif selon la revendication 1, **caractérisé en ce que** la borne du pôle négatif (-SNT), non mis à la masse, sert comme point de mesure de tension pour la tension appliquée (U_{C2}) au condensateur de transfert (C2)

4. Dispositif selon l'une quelconque des revendications 1 ou 2, **caractérisé en ce que** la source de tension (SNT) réglable par le circuit de commande (ST) est un bloc d'alimentation.

5. Dispositif selon l'une quelconque des revendications 1 ou 2, **caractérisé en ce que** le circuit de commande (ST) est une partie d'un dispositif de commande de moteur commandé par microprocesseur.

6. Dispositif selon l'une quelconque des revendications 1 ou 2, **caractérisé en ce que** l'interrupteur de charge (X1) et l'interrupteur de décharge (X2) sont des interrupteurs commandés, électroniques, comprenant au moins un élément semi-conducteur et laissant passer le courant seulement dans un sens.

7. Procédé pour le fonctionnement du dispositif selon l'une quelconque des revendications 1 ou 2, **caractérisé en ce que** l'actionneur à commander (P₁ à Pₙ) concerné est chargé via la bobine d'oscillation (L) à la tension de consigne (Uₛ) à partir du montage en série du condensateur de charge (C1) et du condensateur de transfert (C2), et est à nouveau déchargé dans le condensateur de transfert (C2), et
qu'avant le cycle de charge suivant, le condensateur de charge (C1) est
rechargé à une tension (U_{c1} = Uₛ - U_{c2}) correspondant à la différence entre la tension de consigne (Uₛ) et la tension (U_{c2}) du condensateur de transfert (C2).
